(19) **Europäisches Patentamt**

**European Patent Office**

**Office européen des brevets**

(11) **EP 1 632 782 A1**

(12) **EUROPEAN PATENT APPLICATION**

(43) Date of publication:
**08.03.2006 Bulletin 2006/10**

(51) Int Cl.:
***G01R 31/36*** *(2006.01)*

(21) Application number: **04255321.4**

(22) Date of filing: **02.09.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(71) Applicant: **Delphi Technologies, Inc.**
**Troy, MI 48007 (US)**

(72) Inventor: **Heise, Volker**
**54293 Trier (DE)**

(74) Representative: **Jones, Keith William et al**
**Murgitroyd & Company**
**Scotland House**
**165-169 Scotland Street**
**Glasgow G5 8PL (GB)**

(54) **Method and apparatus for battery monitoring**

(57)    The invention teaches a method for battery monitoring as well as an apparatus provided to perform that method where the method employs two test loads (21, 23) which are connectable to the battery (10) and where the discharge stages resulting from the connection of the test loads (21, 23) to the battery are analysed in order to monitor the battery's internal resistance or impedance.

*Fig. 1*

EP 1 632 782 A1

**Description**

The present invention relates to a method for battery monitoring, especially a battery used in or for use in a vehicle such as an automobile and to an apparatus provided to accomplish the method. With regards to battery monitoring, monitoring generally refers to determining or calculating characteristic electrical values, such as the internal resistance or impedance of the battery, its open circuit voltage, etc.

Statistics of so-called vehicle "walk home failures", i.e failures that result in the vehicle driver having to walk home, identify problems with the battery charging system as a significant root cause. The increasing number of electrical components in modern automobiles, both for comfort and safety, require more and more electric energy. To increase the reliability of such electric systems a battery / energy monitoring system is required. Simple battery monitoring by some kind of battery voltage observation and interpretation provides very limited information about real battery capacity.

GB 2 397 656 teaches a battery monitoring system employing a monitoring circuitry that connects a test load to the battery via a solid-state switch for short amounts of time and measures the voltage across the test load. The microcontroller controls the length of time the switch is closed, and this is typically made very short in order to ensure that the electrical energy dissipated by the test load is very small. The monitoring system is provided to measure the internal impedance or the terminal voltage of the battery alternatively and to predict a remaining lifespan and condition of the battery.

However, this known battery monitoring system does not account for factors like polarisation, gassing and battery usage history, etc.

The object of the present invention is to provide an improved battery monitoring system. A further object of the invention is to provide monitoring means and/or a monitoring method overcoming the problems and drawbacks described above. Yet a further object of the invention is to provide a method capable of monitoring the battery during operation, e.g. when the vehicle's engine is running and the battery is recharged by means of a generator driven by the engine in a conventional manner.

This is achieved by carrying out the method having the features disclosed in claim 1 and by an apparatus provided to perform that method having the features disclosed in claim 7.

Said method for monitoring an electrical energy source, especially a battery used in a vehicle, comprises the steps of:

   connecting a first test load to the battery,
   measuring the voltage and the current across said first test load,
   connecting a second test load to the battery,
   measuring the voltage and the current across said second test load and
   calculating the internal resistance or the impedance of the battery according to the voltage and current measured during connection of the first and second test load to the battery.

The test loads may be connected in a consecutive individual manner or in a consecutive additional manner, i.e. the second test load may be connected to the battery with or without the first test load being connected to the battery. If the first test load is not disconnected prior to connecting the second test load then the method would comprise a step wherein during the steps of connecting the second test load to the battery and measuring the voltage and the current across said second test load the first test load is still connected to the battery as well.

The method employs two test loads, connected consecutively to the battery. Monitoring the battery with a double test load, especially with a double transistor load device without a running engine, i.e. without a running generator, provides very consistent results and can be used to determine the internal resistance ($R_i$), which is proportional to the power capabilities of the battery, before cranking.

The consistency of the results is further improved if the step of measuring the voltage and the current across the first or second test load comprises the steps of:

   taking a predetermined number of measures of voltage and current,
   calculating the average of the measures and
   applying the average of the voltage and current measures when calculating the internal resistance of the battery.

Accounting only for the average of a number of measures results in eliminating or at least levelling any faults, errors or side effects that would otherwise bias the measure and the subsequent calculation.

The consistency of the results is still further improved if the step of measuring the voltage and the current across the first or second test load comprises the steps of:

   taking a predetermined number of measures of voltage and current,

calculating the average and standard deviation of the measures,

checking whether or not the standard deviation exceeds a predetermined threshold, and

applying the average of the voltage and current measures when calculating the internal resistance of the battery provided that the standard deviation of the measure did not exceed said predetermined threshold.

By calculating the standard deviation of the consecutive measures taken when the first or second test load is connected to the battery it is possible to discard a series of measures or even restart the monitoring process if the standard deviation exceeds a predetermined threshold, i.e. if the readings of voltage and current are not at least distributed within a certain range. In other words: if the standard deviation exceeds that threshold then the reading of current and/or voltage is too faulty or too much influenced by side effects, parasitic induction or similar negative effects. Since the calculation of the internal resistance of the battery is not to be based on faulty readings such readings are discarded.

The individual steps of the method are preferably activated or triggered by means of the current or voltage reading itself. This enables the method to measure the voltage and the current across the first or second test load when or shortly after the first or second test load is connected to the battery. The instance of time when the first or second test load is connected to the battery is detected from a falling edge in the current or voltage measure.

The consistency of the results is yet further improved if a generator, which is usually present in an electrical system of a vehicle, is prevented from regulating against the connection of the test load. This is achieved in that the time during which the first or second test load is connected to the battery is short with respect to a time constant of a generator connected to the battery. Preferably the duration of the load pulses, i.e. the time during which the first or second test load is connected to the battery, is as low as 5ms to 10ms. The high impedance of typically used generators will not influence the signals since their time constant is in an area of 100ms to 150ms due to the inductance of the rotor.

Said apparatus, provided to achieve the objects of the invention, is an apparatus for monitoring an electrical energy source, especially a battery used in a vehicle, comprising of:

a first and second test load,

controlling means for selectively connecting the first or second test load to the battery,

measuring means for measuring the voltage and the current across said first and second test load, and

calculating means for calculating the internal resistance ($R_i$) of the battery according to the voltage and current measurable during connection of the first and second test load to the battery.

In order to facilitate the connection of the first or second test load to the battery, said first and second test load is preferably a double stage transistor load device comprising two branches connected parallel to the battery, each comprising a resistance and a solid state switch interconnected in series. The solid state switches, e.g. a transistor, preferably a MOSFET transistor, can easily be operated by means of the controlling means of the apparatus, e.g. a microcontroller or the like. Transistors and microcontrollers allow for the short reaction time required when connecting the first and second test load to the battery only for the relatively short predetermined amount of time.

If the vehicle's engine is running, i.e. if the battery is recharged by means of a generator, monitoring of the battery can be performed by employing the method of claim 10. Said method for monitoring an electrical energy source, especially a battery, used in a vehicle such as an automobile and charged during said vehicle's engine is run by means of a generator, comprising the steps of:

measuring the voltage and the current when said battery is charged by means of said generator across the battery or the generator,

detecting both the maximum and the minimum of both voltage and current within a predetermined amount of time, and

calculating the internal resistance ($R_i$) of the battery according to the maximum and minimum voltage and current measures.

The above method can be improved when the step of measuring the voltage and the current across the battery, comprises the step of calculating the average of the measures and applying said average when calculating the internal resistance. The method may be yet further improved by calculating the standard deviation of the readings, where the internal resistance is calculated according to the readings or the reading's average only when the standard deviation did not exceed a predetermined threshold.

The consistency of the monitoring results may be improved in that said predetermined amount of time is defined by the duration of a predetermined number of consecutive ripple periods caused by the generator when charging the battery.

The object of the invention is also achieved by carrying out a method having the features disclosed in claim 13. Said method for monitoring an electrical energy source, especially a battery used in a vehicle, comprises the steps of:

applying a predetermined load characteristic on the battery,
measuring the voltage and the current across the battery when the load characteristic is applied on the battery, and
calculating the impedance of the battery according to the voltage and current measures.

The idea behind this approach is to provide a load characteristic imitating a half-wave of a sine curve. Such a load characteristic can be obtained by employing two test loads connected to the battery consecutively in a predetermined manner, that is the load characteristic is preferably obtained either by

connecting a first test load to the battery for a first predetermined amount of time,
connecting a second test load to the battery for a second predetermined amount of time when the first test load has been connected to the battery for some time, and
disconnecting the second test load from the battery while the first test load is still connected to the battery or by connecting a first test load to the battery for a first predetermined amount of time,
disconnecting the first test load from the battery and connecting a second test load to the battery for a second predetermined amount of time, and
disconnecting the second test load from the battery and connecting the first test load to the battery for the first predetermined amount of time. The relation between the first and second predetermined amount of time and more specifically the overall duration ($t_{dur}$) of the load characteristic determines the fundamental frequency of the frequency spectrum ($f_1$) associated with the load characteristic. It has been found to be beneficial that the relation between the first and second predetermined amount of time is either that
the first predetermined amount of time is essentially thrice as long as the second predetermined amount of time or that the first predetermined amount of time essentially equals the second predetermined amount of time.

It has further been found to be beneficial when calculating the impedance of the battery with respect to a predetermined desired frequency or frequency spectrum ($f_d$) that a frequency spectrum ($f_1$) of the load characteristic has at least one single dominant harmonic within the desired frequency spectrum ($f_d$).
It has yet further been found to be beneficial to obtain or store the voltage and current readings at a sampling rate of at least twice the desired frequency ($f_d$).
It has still further been found to be beneficial when the duration ($t_{dur}$) of the load characteristic is related to the desired frequency, e.g. in that $t_{dur} = 10/f_d$.
Other features and advantages of the present invention will appear from the following description of preferred embodiments of the invention, given as non-limiting examples, illustrated in the drawings. All the elements which are not required for the immediate understanding of the invention are omitted. In the drawings, the same elements are provided with the same reference numerals in the various figures, and in which

Fig 1 is a schematic circuit diagram of a battery system in a vehicle,
Fig 2 is a more detailed schematic circuit diagram of such a battery system,
Fig 3 is a schematic depiction of the power output of the battery in terms of current and voltage readings,
Fig 4 is a flow chart of the steps of the method proposed according to the invention,
Fig 5 is a schematic depiction of the power output of the battery in terms of current and voltage readings when the battery is charged,
Fig 6 is a schematic depiction of a load characteristic applicable to the battery in another embodiment of the invention,

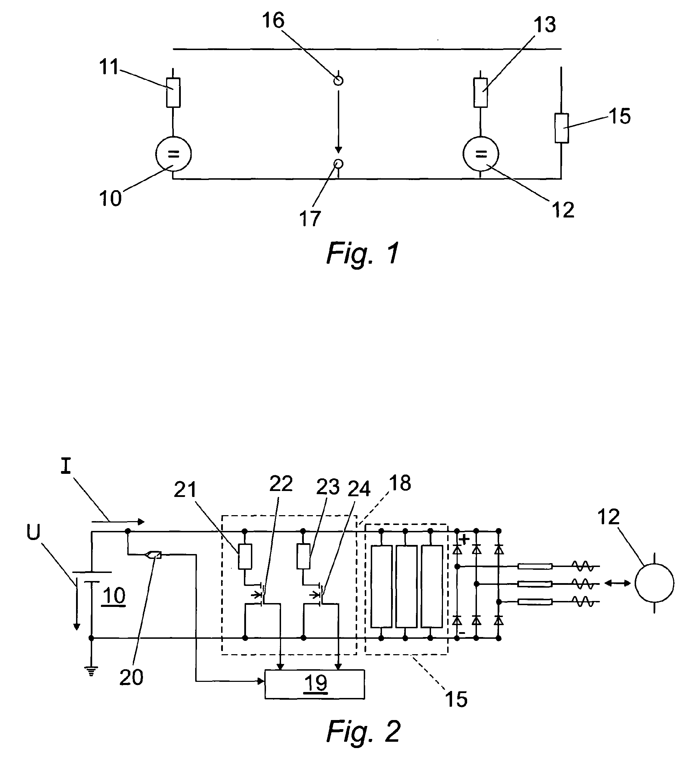

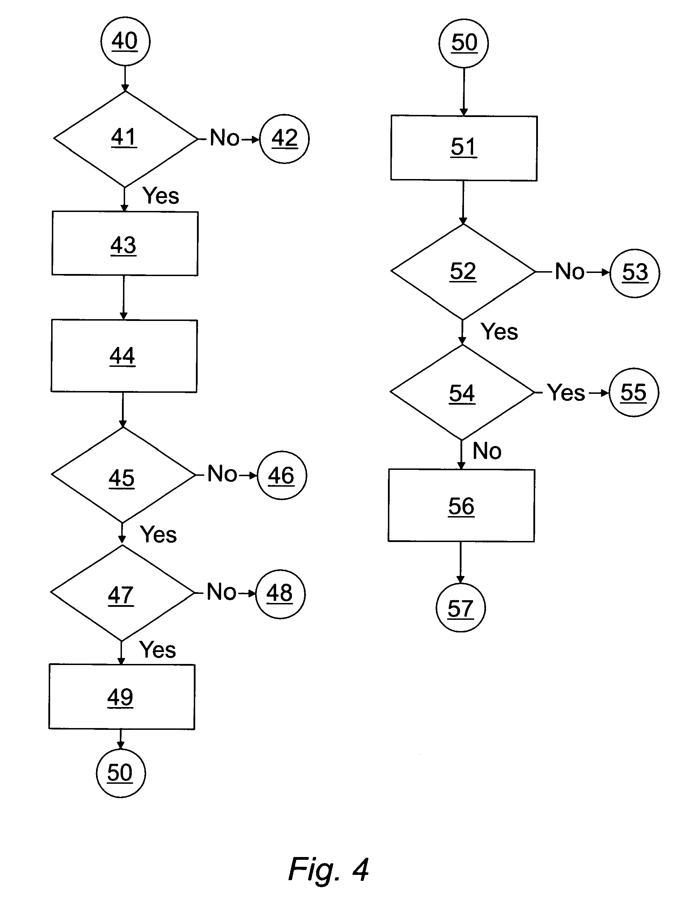

Fig 1 is a schematic circuit diagram of a battery system in a vehicle, said battery system having battery 10 with an internal resistance 11, a generator 12 provided as a means for recharging the battery during operation of an engine (not shown) of the vehicle, e.g. an automobile. The generator 12 also has an internal resistance 13. Battery 10 and generator 12 are interconnected in parallel. Likewise parallelly connected to the battery and the generator 12 is a load 15, schematically depicted as a single resistance. Two contacts 16, 17 are provided as a means for measuring the voltage across the battery 10 or as a means for connecting a test load to the battery.
Fig 2 is another, more detailed schematic circuit diagram of a battery system in a vehicle. Connected to the battery 10 is a double stage transistor load device 18 which is controlled and operated by a control device 19 (or controller 19). The control device 19 itself operates according to voltage and/or current readings from a battery sensor 20. The double stage transistor load device 18 (or load device 18) comprises two branches connected parallel to the battery 10, each comprising a first and a second resistance 21, 23 and a first and second solid state switch 22, 24 interconnected in series. The resistance 21, 23 in each branch is the actual test load. Therefore, in the following a first and a second test load is denoted as 21, 23 as well and the terms are used synonymously. The control device 19 is an exemplary embodiment of the controlling means 19 for selectively connecting the first or second test load 21, 23 to the battery 10 and of the calculating means 19 for calculating the internal resistance ($R_i$) of the battery 10 according to the voltage and current measurable during connection of the first and second test load 21, 23 to the battery 10. The battery sensor 20 is an exemplary embodiment of the measuring means 20 for measuring the voltage and the current across said first and second test load 21, 23.

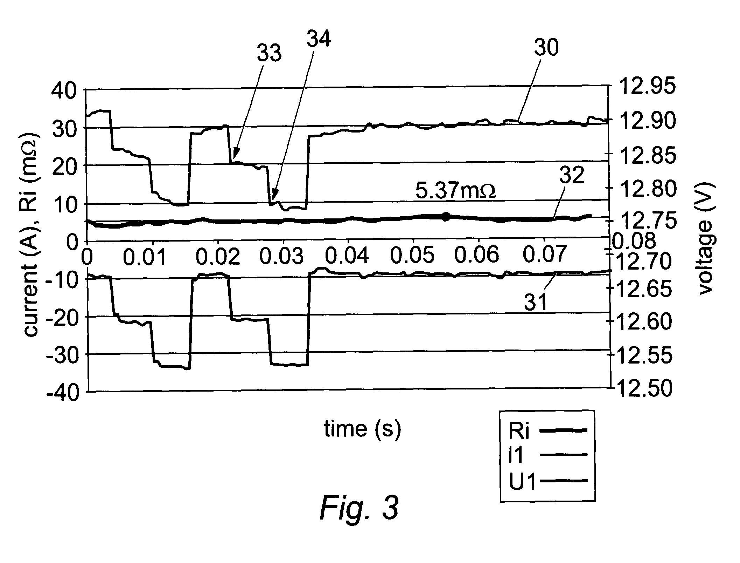

Fig 3 is a schematic depiction of the power output of the battery 10 (Fig. 1, 2) in terms of current and voltage readings. Voltage curve 30 depicts the voltage readings from the battery sensor 20 over the time. Accordingly, current curve 31 depicts the current readings from the battery sensor 20 over the time. The internal resistance ($R_i$) of the battery 10 can be calculated with respect to corresponding current and voltage readings. A curve of the internal resistance - resistance curve 32 - is depicted in Fig. 3 as well.

Both the voltage and the current curve 30, 31 show a characteristic step formation 33, 34 caused by consecutively connecting the first and second test load 21, 23 to the battery 10. Each step formation 33, 34 comprises a falling edge or falling flank and a subsequent plateau. The falling edge of each step formation 33, 34 is indicative of the connection of the first or second test load 21, 23 to the battery 10 and is therefore employed to trigger the measuring of the voltage and the current across the first or second test load 21, 23, e.g. taking a predetermined number of measures of voltage and current.

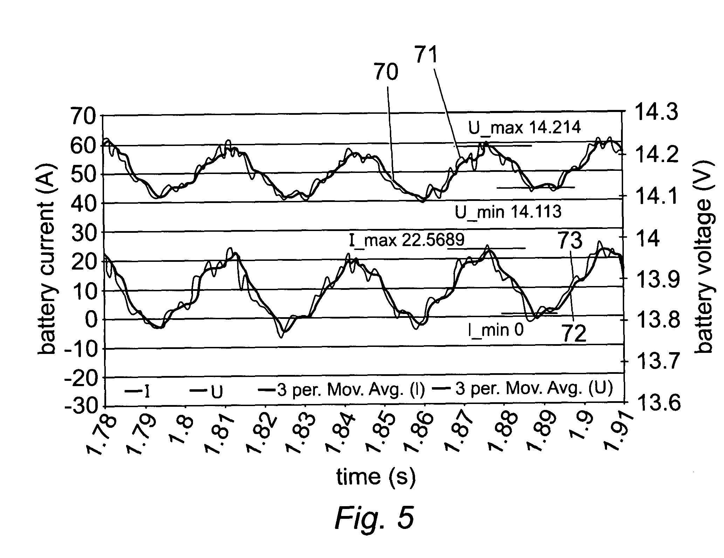

Fig. 4 is a flow chart of an algorithm provided to perform the steps of the method proposed according to the invention, in which step 40 is a first step of the flow chart and is used to initialise data and variables and may be used to calibrate the measuring means employed, such as the battery sensor 20. Step 41 is concerned with the detection of the first step formation 33, caused by the connection of the first test load 21 to the battery 10. If the first step formation 33, e.g. the falling edge initiating the first step formation 33, is detected the algorithm commences with the next step. If, however, the first step formation 33 is not detected, e.g. not detected within a predetermined amount of time, than the algorithm branches to step 42 which in turn terminates the algorithm and causes restart of the algorithm at step 40. If the algorithm is not terminated the next step is step 43 where the voltage and the current across the first test load 21 connected to the battery 10 is measured. Measuring the voltage and current is preferably carried out in taking n samples of both voltage and current within a predetermined amount of time during the connection of the first test load 21 to the battery 10. The data read in step 43 is further processed in the following step 44 in which the average and the standard deviation of the voltage and current readings is calculated. The next step 45 is provided in order to ensure the accuracy and consistency of the acquired data, i.e. the voltage and current readings. This is accomplished by checking whether or not the calculated standard deviation for both the voltage and current data exceeds a predetermined threshold. Should the standard deviation of one of the data sets exceed the respective threshold, the algorithm will branch to step 46 which in turn terminates the algorithm and causes the restart of the algorithm at step 40. If the standard deviation of both sets of data is below the relevant threshold the algorithm commences with step 47 which is concerned with ensuring that the second step formation 34 is detected within a predetermined amount of time. Should the second step formation 34 not be detected within that predetermined amount of time the algorithm will branch to step 48 which in turn terminates the algorithm and causes the restart of the algorithm at step 40. If the second step formation 34 is in fact detected within due time the algorithm commences at step 49 in which, similar to the processing in step 43, the voltage and the current across the second test load 23 connected to the battery 10 is measured resulting in two additional sets of data both for current and voltage. The algorithm commences at step 50 which is inserted as a means for bridging the graphical representation of the algorithm. The next step 51 is similar to step 44 and is provided in order to calculate the average and standard deviation for the second set of data. Steps 52 and 53 correspond to steps 45 and 46 and are provided in order to ensure that the algorithm only commences as long as the standard deviation calculated in step 51 is below the relevant predetermined threshold value. Checking the standard deviation both for the current and voltage readings against a respective predetermined threshold value (steps 45 and 52) ensures that the voltage or current signal is sufficiently reliable (= stable signal) for the subsequent processing. Step 54 provides for a check of a possible quadrant change, i.e. a zero crossing, for the readings of the battery current between step 43 and step 49. If such a quadrant change happens between step 43 and step 49 then the algorithm will branch to step 55 which in turn terminates the algorithm and causes the restart of the algorithm at step 40. A final step 56 is provided to calculate the internal resistance ($R_i$) of the battery according to the current and voltage measures obtained during step 43 and step 49. More specifically, the internal resistance ($R_i$) is calculated according to the following formula

$$R_i = \Delta U\ /\ \Delta I = (\ U_1 - U_2\ )\ /\ (\ I_1 - I_2\ ),$$

where $R_i$ is the internal resistance of the battery (10), $U_1$ or $U_2$ is a voltage reading or the average of the voltage readings when the first or second test load 21, 23 is connected to the battery 10 respectively (steps 43, 49) and $I_1$ or $I_2$ is a current reading or the average of the current readings when the first or second test load 21, 23 is connected to the battery 10 respectively (steps 43, 49).

Fig. 5 is a schematic depiction of the current 70, 71 and the voltage 72, 73 across the battery 10 or the generator 12 when the battery 10 is charged by means of the generator 12. The bold graph 70, 72 represents an average of the voltage or current readings which is calculated by means of a moving average function. The thin graph 71, 73 represents the factual readings. The method for monitoring the battery 10 when the same is charged during operation of the vehicle's engine comprises the steps of

measuring the voltage and the current when said battery 10 is charged by means of said generator 12,
detecting both the maximum and the minimum of both voltage and current within a predetermined amount of time, and calculating the internal resistance ($R_i$) or impedance of the battery 10 according to the maximum and minimum voltage and current measures.

Exemplary maximum and minimum voltage and current measures for the graphs 70-73 shown in Fig. 5 are depicted in Fig. 5 as "U_max", "U_min", "I_max" and "I_min". As soon as these values are obtained the internal resistance ($R_i$) of the battery 10 is calculated according to the following formula

$$R_i \; = \; \Delta U \; / \; \Delta I \; = \; ( \; U_{max} \; - \; U_{min} \; ) \; / \; ( \; I_{max} \; - \; I_{min} \; ),$$

where $R_i$ is the internal resistance of the battery 10, Umax or $U_{min}$ and $I_{max}$ or $I_{min}$ are the maximum and minimum voltage and current measures occurring within that predetermined amount of time. Said predetermined amount of time is preferably defined by the duration of a predetermined number of consecutive ripple periods, where a ripple period is either a complete sine wave of the bold graph 70, 72 or if the measuring method allows for a more detailed resolution a complete sine wave of the thin graph 71, 73. Said predetermined number of consecutive ripple periods is preferably greater or equal to ten consecutive ripple periods or smaller or equal to ten consecutive ripple periods.

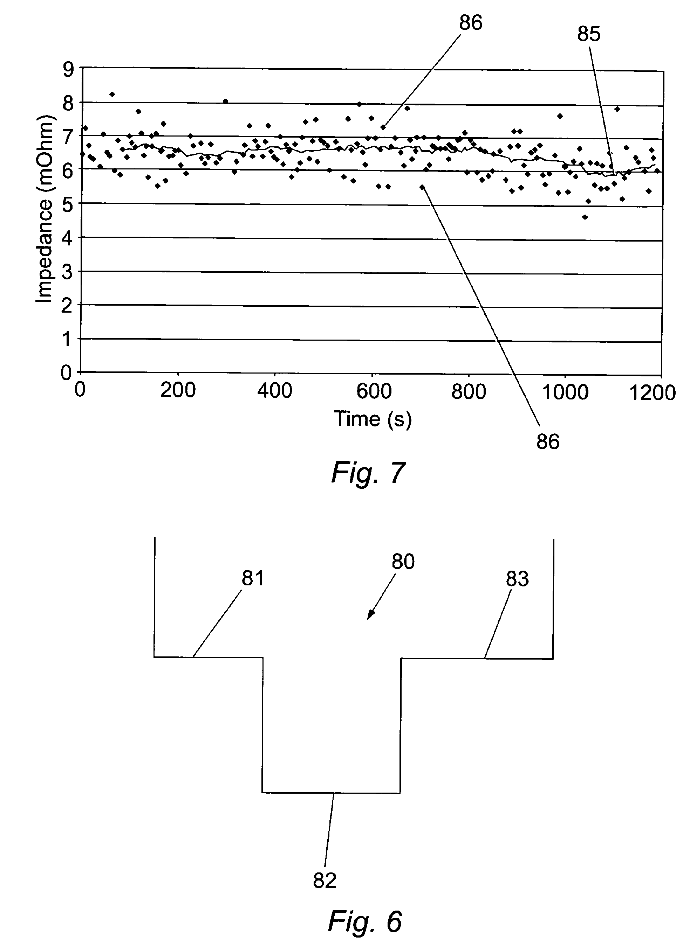

Another embodiment of the invention relies on applying a characteristic load 80 to the battery 10 as depicted schematically in Fig. 6. The load characteristic 80 is similar to the step formation 33, 34 (Fig. 3). However, the load characteristic 80 is symmetrical, comprising a first step formation 81, a second step formation 82 and a third step formation 83, where the first and third step formations are essentially equal. The load characteristic 80 roughly resembles a sine half-wave. The load characteristic 80 can easily be obtained by connecting the first and second test load 21, 23 to the battery 10 by means of the controller 19. The load characteristic 80 is a series of defined on/off load states such that a frequency spectrum associated with the load characteristic 80 has one single dominant harmonic in the desired frequency spectrum, i.e. the frequency spectrum for which the impedance of the battery 10 is to be monitored, or one single dominant harmonic which equals the desired frequency ($f_d$), i.e. the frequency for which the impedance of the battery 10 is to be monitored. During the application of the load characteristic 80 to the battery 10, which is preferably applied in equidistant instances of time, voltage and current readings across the first and/or second test load 21, 23 shall be stored at least at a sampling rate ($t_s$) of twice the desired frequency ($f_d$) : $t_s \geq 2 \times f_d$. In an exemplary embodiment where the impedance of the battery 10 is to be monitored for a desired frequency ($f_d$) of 36Hz this would result in a sampling rate of $t_s$ = 1ms.

The load characteristic 80 is applied to the battery 10 in a non-continuous manner. The load characteristic 80 is applied to the battery 10 in the form of a "single burst". It has been found to be beneficial that the overall duration, during which the load characteristic 80 is in fact applied to the battery 10, or the overall duration of a single burst is related to the desired frequency ($f_d$) for which the impedance of the battery 10 is to be monitored. A preferred relation between said overall duration ($t_{dur}$) and the desired frequency ($f_d$) could be expressed as:

$$T_{dur} \; \leq \; 10 \; \times \; ( \; 1 \; / \; f_d \; ).$$

The voltage and current data retrieved during appliance of the load characteristic 80 to the battery 10, as depicted in Fig 7, is processed using the method of discrete Fourier Transformation or Fast Fourier Transformation or any other suitable method of spectral analysis. The processed data is filtered as such that at least one single harmonic of current and voltage is used to create the following result:

$$|z_d| = |u_d| \; / \; |i_d|,$$

where $z_d$ is the impedance (z) of the battery 10 for the desired frequency ($f_d$) and $u_d$ and $i_d$ are voltage and current readings during appliance of the load characteristic 80.

Fig. 5 shows a resulting impedance curve 85 and the underlying discrete impedance values ($z_d$) 86, where the impedance curve 85 is derived from the discrete impedance values 86 by means of calculating an average, preferably a moving average.

In short, the invention teaches a method for battery monitoring as well as an apparatus provided to perform that method where the method employs two test loads 21, 23 which are connectable to the battery 10 and where the discharge stages resulting from the connection of the test loads 21, 23 to the battery are analysed in order to monitor the battery's internal resistance or impedance.

Although a preferred embodiment of the invention has been illustrated and described herein, it is recognised that changes and variations may be made without departing from the invention as set forth in the claims.

**Claims**

1. A method for monitoring an electrical energy source, especially a battery (10) used in a vehicle, said method comprising the steps of:

   connecting a first test load (21) to the battery (10),
   measuring the voltage and the current across said first test load (21),
   connecting a second test load (23) to the battery (10),
   measuring the voltage and the current across said second test load (23) and
   calculating the internal resistance ($R_i$) or impedance ($z_d$) of the battery (10) according to the voltage and current measured during connection of the first and second test load (21, 23) to the battery (10).

2. A method according to claim 1, wherein during the steps of connecting the second test load (23) to the battery (10) and measuring the voltage and the current across said second test load (23) the first test load (21) is still connected to the battery (10) also.

3. A method according to claim 1 or claim 2, wherein the step of measuring the voltage and the current across the first or second test load (21, 23) comprises the steps of:

   taking a predetermined number of measures of voltage and current,
   calculating the average of the measures, and
   applying the average of the voltage and current measures when calculating the internal resistance of the battery.

4. A method according to claim 1 or claim 2, wherein the step of measuring the voltage and the current across the first or second test load (21, 23) comprises the steps of:

   taking a predetermined number of measures of voltage and current,
   calculating the average and standard deviation of the measures,
   checking whether or not the standard deviation exceeds a predetermined threshold, and
   applying the average of the voltage and current measures when calculating the internal resistance of the battery provided that the standard deviation of the measure did not exceed said predetermined threshold.

5. A method according to any of the preceding claims, wherein the step of measuring the voltage and the current across the first or second test load (21, 23) is performed when or shortly after the first or second test load (21, 23) is connected to the battery and wherein the connection of the first or second test load (21, 23) to the battery is detected from a falling edge in a current or voltage measure.

6. A method according to any of the preceding claims, wherein the time during which the first or second test load (21, 23) is connected to the battery (10) is short with respect to a time constant of a generator connected to the battery (10).

7. An apparatus for monitoring an electrical energy source, especially a battery (10) used in a vehicle, comprising:

   a first and second test load (21, 23),
   controlling means (19) for selectively connecting the first or second test load (21, 23) to the battery,
   measuring means (20) for measuring the voltage and the current across said first and second test load (21, 23), and
   calculating means (19) for calculating the internal resistance ($R_i$) of the battery (10) according to the voltage and current measurable during connection of the first and second test load (21, 23) to the battery (10).

8. An apparatus according to claim 7, wherein the first and second test load (21, 23) is a double stage transistor load device (18) comprising of two branches connected parallel to the battery (10), each comprising a resistance (21, 23) and a solid state switch (22, 24) interconnected in series.

9. An apparatus according to claim 8, wherein said controlling means (19) is provided to activate each of the solid state switches (22, 24).

10. A method for monitoring an electrical energy source, especially a battery (10), used in a vehicle such as an automobile and charged while said vehicle's engine is running by means of a generator (12), said method comprising the steps of:
measuring the voltage and the current when said battery (10) is charged by means of said generator (12) across the battery (10),
detecting both the maximum and the minimum of both voltage and current within a predetermined amount of time, and calculating the internal resistance ($R_i$) of the battery (10) according to the maximum and minimum voltage and current measures.

11. A method according to claim 10, wherein the step of measuring the voltage and the current across the battery (10), comprises the step of calculating the average of the measures.

12. A method according to claim 10 or claim 11, wherein said predetermined amount of time is defined by the duration of a predetermined number of consecutive ripple periods.

13. A method for monitoring an electrical energy source, especially a battery (10) used in a vehicle, said method comprising the steps of:

applying a predetermined load characteristic (80) to the battery,
measuring the voltage and the current across the battery (10) when the load characteristic (80) is applied to the battery (10),
calculating the impedance of the battery (10) according to the voltage and current measures.

14. A method according to claim 13, wherein said load characteristic (80) is obtained either by
connecting a first test load (21) to the battery (10) for a first predetermined amount of time,
connecting a second test load (23) to the battery (10) for a second predetermined amount of time, and
disconnecting the second test load (23) from the battery (10) while the first test load (21) is still connected to the battery (10)
or by
connecting a first test load (21) to the battery (10) for a first predetermined amount of time,
disconnecting the first test load (21) from the battery (10) and connecting a second test load (23) to the battery (10) for a second predetermined amount of time and
disconnecting the second test load (23) from the battery (10) and connecting the first test load (21) to the battery (10) for the first predetermined amount of time.

15. A method according to claim 14, wherein the relation between the first and second predetermined amount of time is either that
the first predetermined amount of time is essentially thrice as long as the second predetermined amount of time
or that
the first predetermined amount of time essentially equals the second predetermined amount of time.

16. A method according to any one of the claims 13 to 15, wherein the impedance of the battery (10) is calculated with respect to a predetermined desired frequency or frequency spectrum ($f_d$) and wherein a frequency spectrum ($f_1$) of the load characteristic (80) has at least one single dominant harmonic within the desired frequency spectrum ($f_d$).

17. A method according to any one of the claims 13 to 16, wherein the voltage and current reading is stored at a sampling rate of at least twice the desired frequency.

18. A method according to any one of the claims 13 to 17, wherein a duration ($t_{dur}$) of the load characteristic (80) is related to the desired frequency ($f_d$).

**Fig. 1**

**Fig. 2**

Fig. 4

Fig. 3

*Fig. 5*

*Fig. 7*

*Fig. 6*

European Patent Office

**EUROPEAN SEARCH REPORT**

Application Number

EP 04 25 5321

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | PATENT ABSTRACTS OF JAPAN vol. 012, no. 216 (P-719), 21 June 1988 (1988-06-21) & JP 63 012981 A (MITSUBISHI ELECTRIC CORP), 20 January 1988 (1988-01-20) * abstract * | 1,2,7 | G01R31/36 |
| X | PATENT ABSTRACTS OF JAPAN vol. 007, no. 238 (P-231), 22 October 1983 (1983-10-22) & JP 58 123479 A (NISSAN JIDOSHA KK), 22 July 1983 (1983-07-22) * abstract * | 1,7 | |
| X | US 5 352 968 A (RENI ET AL) 4 October 1994 (1994-10-04) * column 7, line 3 - column 7, line 32; figures 5-7 * | 1,7 | |
| A | US 2002/121901 A1 (HOFFMAN GARY) 5 September 2002 (2002-09-05) * abstract; figure 1 * | 1,2,7 | TECHNICAL FIELDS SEARCHED (Int.Cl.7) |
| A | EP 0 544 121 A (IVECO FIAT S.P.A) 2 June 1993 (1993-06-02) * abstract; figure 2 * | 1,2,7,8 | G01R |
| A | US 6 087 808 A (PRITCHARD ET AL) 11 July 2000 (2000-07-11) * column 4, line 33 - column 7, line 67; figures 2,3 * | 1,7 | |
| A | US 5 365 453 A (STARTUP ET AL) 15 November 1994 (1994-11-15) * figures 1,3 * | 1,7 | |

-/--

The present search report has been drawn up for all claims

| Place of search | Date of completion of the search | Examiner |
|---|---|---|
| The Hague | 19 April 2005 | Vytlacilová, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 1 632 782 A1

**European Patent Office**

**EUROPEAN SEARCH REPORT**

EP 04 25 5321

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | WO 2004/073088 A (EDISON SOURCE; MICHALSKI, PETER, G; FIELD, ROBERT, B; PICKERING, G., R) 26 August 2004 (2004-08-26) * paragraph '0047!; table 2 * | 10 | |
| A | DE 103 09 913 B3 (AUDI AG) 19 August 2004 (2004-08-19) * figure 1 * | 10 | |
| X | US 2004/076872 A1 (KINOSHITA TAKUYA ET AL) 22 April 2004 (2004-04-22) * figures 9,10 * | 13 | |
| X | US 2003/067282 A1 (ARAI YOUICHI ET AL) 10 April 2003 (2003-04-10) * figure 1 * | 13 | |
| A | AU 2003 296 666 A1 (FRAUNHOFER-GESELLSCHAFT ZUR FORDERUNG DER ANGEWANDTEN FORSCHUNG E.V) 9 July 2004 (2004-07-09) * figure 1 * | 13 | |
| A | EP 0 560 468 A (GLOBE-UNION INC; C&D/CHARTER HOLDINGS, INC) 15 September 1993 (1993-09-15) * figure 1 * | 13,14 | |
| A | US 4 968 942 A (PALANISAMY ET AL) 6 November 1990 (1990-11-06) * figure 3 * | 13,14 | |
| A | US 6 061 639 A (WISTRAND ET AL) 9 May 2000 (2000-05-09) * abstract * | 13,14 | |

TECHNICAL FIELDS SEARCHED (Int.Cl.7)

-/--

The present search report has been drawn up for all claims

| Place of search | Date of completion of the search | Examiner |
|---|---|---|
| The Hague | 19 April 2005 | Vytlacilová, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

15

European Patent
Office

# EUROPEAN SEARCH REPORT

**Application Number**

EP 04 25 5321

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | WO 97/15839 A (GLOBE-UNION, INC)<br>1 May 1997 (1997-05-01)<br>* abstract * | 13,14 | |

**TECHNICAL FIELDS SEARCHED** (Int.Cl.7)

The present search report has been drawn up for all claims

| Place of search | Date of completion of the search | Examiner |
|---|---|---|
| The Hague | 19 April 2005 | Vytlacilová, L |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

European Patent
Office

Application Number

EP 04 25 5321

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

**European Patent Office**

**LACK OF UNITY OF INVENTION
SHEET B**

Application Number

EP 04 25 5321

The Search Division considers that the present European patent application does not comply with the requirements of unity of invention and relates to several inventions or groups of inventions, namely:

1. claims: 1- 9

   a method and apparatus for monitoring an electrical energy source using two test loads
   ---

2. claims: 10 - 18

   a method and apparatus for monitoring an electrical energy source using maximum and minimum signal detection
   ---

3. claims: 13 - 18

   a method and apparatus for monitoring an electrical energy source using load characteristic
   ---

## ANNEX TO THE EUROPEAN SEARCH REPORT
## ON EUROPEAN PATENT APPLICATION NO.

EP 04 25 5321

This annex lists the patent family members relating to the patent documents cited in the above–mentioned European search report.
The members are as contained in the European Patent Office EDP file on
The European Patent Office is in no way liable for these particulars which are merely given for the purpose of information.

19-04-2005

| Patent document cited in search report | | Publication date | Patent family member(s) | | Publication date |
|---|---|---|---|---|---|
| JP 63012981 | A | 20-01-1988 | NONE | | |
| JP 58123479 | A | 22-07-1983 | NONE | | |
| US 5352968 | A | 04-10-1994 | NONE | | |
| US 2002121901 | A1 | 05-09-2002 | NONE | | |
| EP 0544121 | A | 02-06-1993 | IT | 1250036 B | 30-03-1995 |
| | | | DE | 69225046 D1 | 14-05-1998 |
| | | | DE | 69225046 T2 | 30-07-1998 |
| | | | EP | 0544121 A1 | 02-06-1993 |
| | | | ES | 2115632 T3 | 01-07-1998 |
| US 6087808 | A | 11-07-2000 | AU | 762928 B2 | 10-07-2003 |
| | | | AU | 4370300 A | 10-11-2000 |
| | | | CA | 2370829 A1 | 02-11-2000 |
| | | | CN | 1348544 A | 08-05-2002 |
| | | | EP | 1183766 A2 | 06-03-2002 |
| | | | JP | 2003508727 T | 04-03-2003 |
| | | | WO | 0065705 A2 | 02-11-2000 |
| US 5365453 | A | 15-11-1994 | US | 5268845 A | 07-12-1993 |
| WO 2004073088 | A | 26-08-2004 | US | 2004155661 A1 | 12-08-2004 |
| | | | WO | 2004073088 A2 | 26-08-2004 |
| DE 10309913 | B3 | 19-08-2004 | NONE | | |
| US 2004076872 | A1 | 22-04-2004 | JP | 2004138586 A | 13-05-2004 |
| | | | DE | 10338003 A1 | 13-05-2004 |
| US 2003067282 | A1 | 10-04-2003 | JP | 2003114264 A | 18-04-2003 |
| | | | DE | 10246383 A1 | 30-04-2003 |
| AU 2003296666 | A1 | 09-07-2004 | DE | 10260894 A1 | 22-07-2004 |
| | | | WO | 2004055535 A1 | 01-07-2004 |
| EP 0560468 | A | 15-09-1993 | US | 5321627 A | 14-06-1994 |
| | | | DE | 69328513 D1 | 08-06-2000 |
| | | | DE | 69328513 T2 | 31-08-2000 |
| | | | EP | 0560468 A1 | 15-09-1993 |
| | | | ES | 2145026 T3 | 01-07-2000 |
| | | | JP | 6052903 A | 25-02-1994 |
| US 4968942 | A | 06-11-1990 | US | 4937528 A | 26-06-1990 |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 04 25 5321

This annex lists the patent family members relating to the patent documents cited in the above-mentioned European search report.
The members are as contained in the European Patent Office EDP file on
The European Patent Office is in no way liable for these particulars which are merely given for the purpose of information.

19-04-2005

| Patent document cited in search report | | Publication date | Patent family member(s) | | Publication date |
|---|---|---|---|---|---|
| US 4968942 | A | | EP | 0460117 A1 | 11-12-1991 |
| | | | JP | 4505053 T | 03-09-1992 |
| | | | JP | 3213740 B2 | 02-10-2001 |
| | | | WO | 9010242 A2 | 07-09-1990 |
| | | | DE | 68924169 D1 | 12-10-1995 |
| | | | DE | 68924169 T2 | 21-03-1996 |
| | | | EP | 0438477 A1 | 31-07-1991 |
| | | | JP | 2966870 B2 | 25-10-1999 |
| | | | JP | 4502963 T | 28-05-1992 |
| | | | WO | 9004188 A1 | 19-04-1990 |
| | | | US | 5281919 A | 25-01-1994 |
| US 6061639 | A | 09-05-2000 | SE | 515398 C2 | 30-07-2001 |
| | | | AU | 2721397 A | 19-11-1997 |
| | | | BR | 9702169 A | 20-07-1999 |
| | | | CA | 2226841 A1 | 06-11-1997 |
| | | | CN | 1196796 A ,C | 21-10-1998 |
| | | | EP | 0852015 A1 | 08-07-1998 |
| | | | JP | 2000501507 T | 08-02-2000 |
| | | | NO | 976104 A | 19-02-1998 |
| | | | PL | 324287 A1 | 11-05-1998 |
| | | | SE | 9601639 A | 30-10-1997 |
| | | | WO | 9741448 A1 | 06-11-1997 |
| WO 9715839 | A | 01-05-1997 | AU | 7459096 A | 15-05-1997 |
| | | | WO | 9715839 A1 | 01-05-1997 |

EPO FORM P0459

For more details about this annex : see Official Journal of the European Patent Office, No. 12/82